# EUROPEAN PATENT APPLICATION

(11) **EP 0 544 247 A2**
(43) Date of publication of application: **02.06.1993**
(21) Application number: 92120068.9
(22) Date of filing: 25.11.1992
(51) Int. Cl.: G11C 5/02

(54) **Memory architecture**

(30) Priority: 27.11.1991 US 799515
(71) Applicant: TEXAS INSTRUMENTS INCORPORATED, Dallas Texas 75265 (US)
(72) Inventor: Tran, Hiep V., Carrollton, Texas 75007 (US)
(74) Representative: Schwepfinger, Karl-Heinz, Dipl.-Ing.

(57) **Abstract**

A memory architecture is disclosed which layouts memory components in such a manner as to encourage high speed memory operation under constraints of high memory density.

## Description

### Background of the Invention

Electronic devices and systems such as printers, copiers, electronic storage devices (memories) high definition television, enhanced definition television, telecommunications equipment and systems and computational devices (e.g. calculators, computers including personal computers microcomputers, devices, often provide data storage on an integrated circuit chip. Because these devices often require large amounts of storage space for many applications, these storage devices are embodied in memory, for instance, dynamic random access memories (DRAMs).

In order to achieve an efficiently operating high density memory such as a DRAM, it is necessary to provide an architecture with a layout that is likely to enhance high speed memory operation under the constraint of high memory density. Until now, no memory architecture has existed which was well suited for complying with the foregoing discussed requirements. The following memory architecture forms an integral of the DRAM. This architecture is also an integral part of the above described devices and systems, supplying substantial value to these and other devices and systems in which it is used.

### Brief Description of the Drawings

Reference will now be made, by way of example, to the accompanying drawings, in which:

Figure 1a is a plan view of a first preferred embodiment of the invention.

Figure 1b illustrates a diagram including the wide data path.

Figure 2 illustrates a schematic drawing of a wide data path circuit.

Figure 3 is a plan view of a second preferred embodiment of the invention.

Figure 4 is a plan view of a third preferred embodiment of the invention.

Figure 5 is a plan view of a fourth preferred embodiment of the invention.
Applicable reference numbers and symbols have been carried forward in each drawing.

### Detailed Description of the Invention

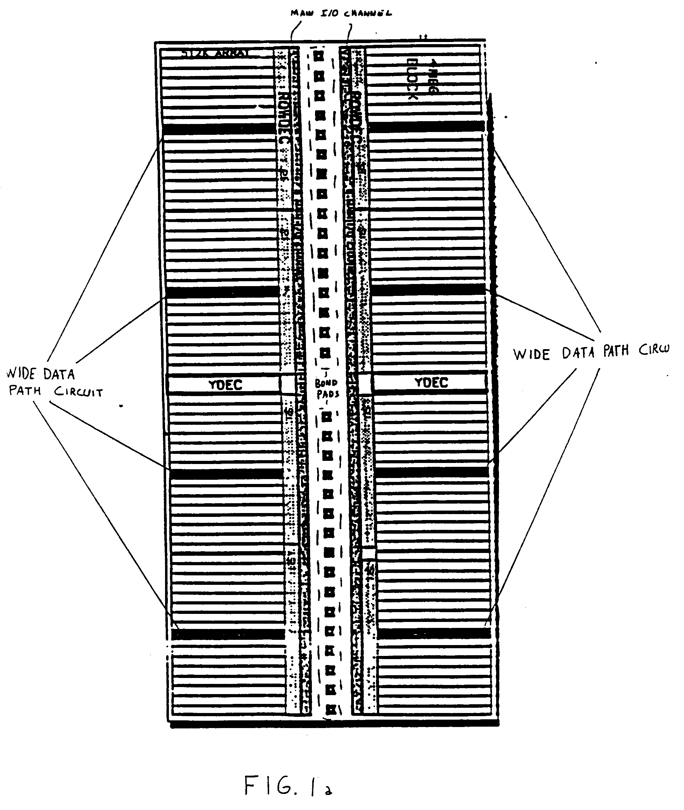

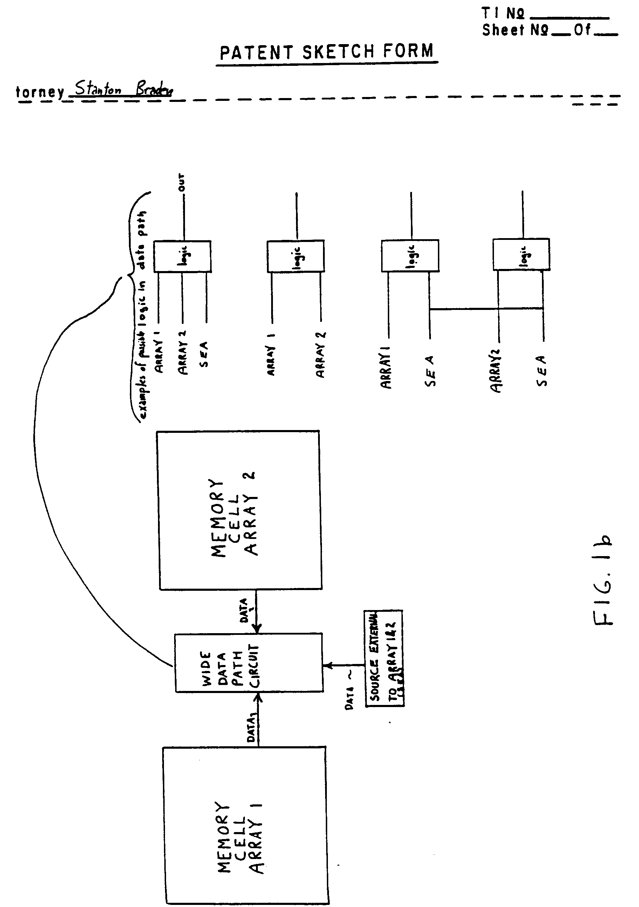

Figure 1 a illustrates a top view of a first preferred embodiment of the invention. Two columns of a plurality of 512k memory arrays (for ease of illustration only one 512k array is specifically labelled) are shown with the memory arrays divided into sets of 8. Each set of eight 512k memory arrays comprise a 4 megabit block. Note that the terms 512k and 4 megabit as used herein throughout in many instances only approximate the actual number of memory cells. Each column of memory arrays is spaced apart from one another along a line interposed between the columns of arrays. Bond pads substantially line up along this line. A Y decoder is substantially centered in the middle of a column of memory arrays. Data path circuits which may be known as wide Data Path Circuits and which can operate on multiple data simultaneously are interspersed in a column between memory arrays after every eighth 512k memory array. Physically, data travels on the path of local input/output lines which are shared by arrays on each side of the wide data path circuit. The wide data path comprises the local input/output lines between memory arrays and the physical space therebetween. As shown in figure 1b, data travelling on said wide data path which originates from either of two memory arrays or a location external the arrays is operated upon by logic connected to the local input/output lines in the wide data path. The logic operation may comprise ANDing, ORing, SHIFTING, complements of the foregoing and combinations thereof.

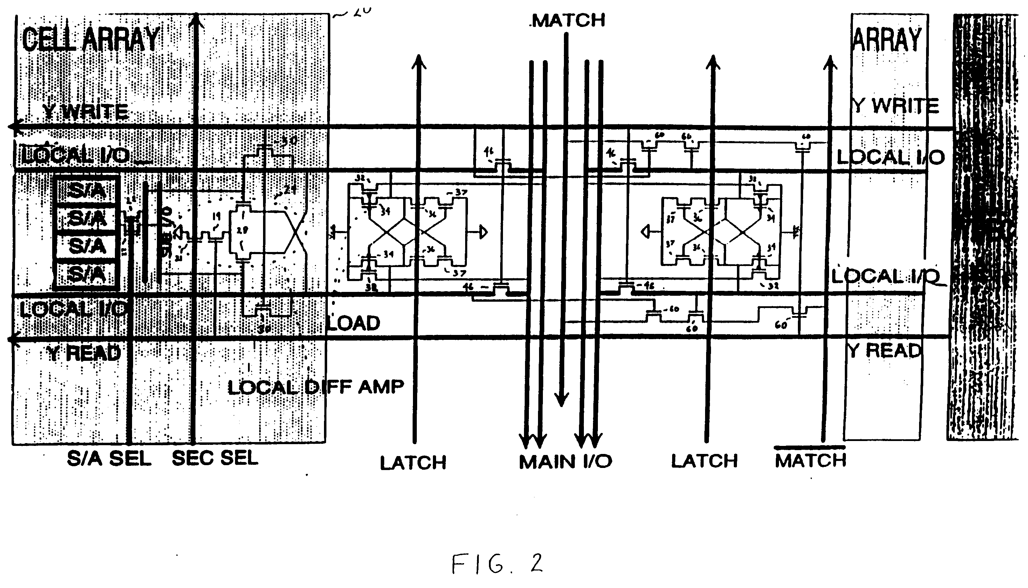

An explanation of the wide data path circuit follows with reference to figure 2. Figure 2 illustrates a read/write data bus scheme which includes a schematic drawing of a wide data path circuit. A wide data path circuit is a circuit for implementing a read/write data bus scheme for high speed DRAM such as a 64 megabit DRAM. main input/output (I/O) lines are interposed between cell arrays. Each cell array 20 (note that only one cell array is shown in detail) contains a plurality of sense amps S/A. Selection of a sense amplifier S/A is governed by a signal from a sense amp select line S/A SEL. Line S/A SEL selects a particular sense amp S/A by delivering a high signal to the gate of a n-channel transistor 22 (note that for illustrative purposes, only two transistors 22 are shown for one sense amplifier even though others are present). A logic high signal on section select line SEC SEL turns on transistor 21 to allow the delivery of information to and from sense amps through local differential amplifier 24 comprised of n-channel transistors 28 and 30 arranged in the symmetrical fashion shown and connected to p-channel load transistors 34. Further details of the wide data path circuit are described in an application by the same inventor of the subject matter herein entitled "Wide Data Path Circuit," filed concurrently herewith, which is hereby incorporated by reference.

READ operations are accomplished by sending a signal from column decoder YDEC along line YREAD. Local I/O line and (a line carrying its complement) line local I/O_are precharged high by circuitry not shown. A high S/A signal allows passage of data from a memory cell (not specifically shown) through a selected sense amp and onto a sub I/O line pair, one line carrying a true signal and the other carrying its complement signal. a differential signal from the sub I/O pair on the gates of each transistor 28 of local differential amplifier 24 in connection with n-channel transistor 19 turning on as a result of a logic high voltage level on line YREAD creates a differential signal on a pair of local I/O lines, line I/O carrying a true signal and line I/O_carrying its complement. Differential signals on the local I/O lines are transferred to a pair of main I/O lines through transistors 32.

In connection with a WRITE operation on a memory cell, column decoder YDEC places a high signal on the gates of transistors 30 after energizing line YWRITE. Data i transferred in through n-channel transistors 46 through a pair of main I/O lines onto local lines I/O and I/O_. A drain /source connection of transistors 230 to a local line (I/O or I/O_) allows differential amplifier 24 to place data on a selected memory cell (not shown) through transistors 22 after selection by S/A SEL from a chosen sense amplifier.

The invention's wide data path circuit greatly facilitates the testing of a memory through its MATCH circuitry. Because of the small geometries involved, it is practically infeasible to test individual memory locations in a memory array. Therefore, the same data is input to each memory cell and latched on local I/O pairs. Latching of data is accomplished by turning on transistors 36, each of which are interposed between n-channel transistors 34 and 37 as shown. The combination of transistors 32, 34, 36, and 37 comprise a latching differential amplifier. although two latching differential amplifiers are shown, it is possible to use only one such amplifier between two arrays of memory, using multiplexed selection to determine access for use by either of the two arrays. One side of the latching differential amplifier is allowed to be pulled low in connection with a high signal on line LATCH. Line MATCH and a line carrying a complemented signal MATCH, are coupled together by each n-channel transistor 60.

In connection with an enabling signal on line YREAD, should be data match in two selected cells (one from each array shown), line MATCH will remain in its precharged state (line MATCH being precharged high prior to a MATCH operation). However, should the data differ, line MATCH will be pulled low through a continuous string of turned on transistor 60 connecting line MATCH to line MATCH. This indicates an error in a armory cell signaling that the integrated circuit memory is defective.

Although only two cell arrays have been shown in figure 2, it should be noted that this testing scheme is applied to all of the cell arrays of the memory.

Returning with reference to figure 1, row decoders generally indicated at 40, lie alongside the columns of memory arrays and lie on an inner edge next to bond pads which provide bonds to the outside environment for functions such as address, control, and input/output. A row decoder is provided for each two 4 megabit blocks of memory as shown. In connection with a signal from a Y decoder, information from/to a sense amplifier (not shown) goes from/to the wide data path circuits which connects to main input/output lines of the memory chip. A channel for placement of the main input/output lines is shown along an edge of the row decoders. The provision of a plurality of wide data path circuits to the extent of 8 per set of 512k memory arrays allows parallel processing and thus increased speed.

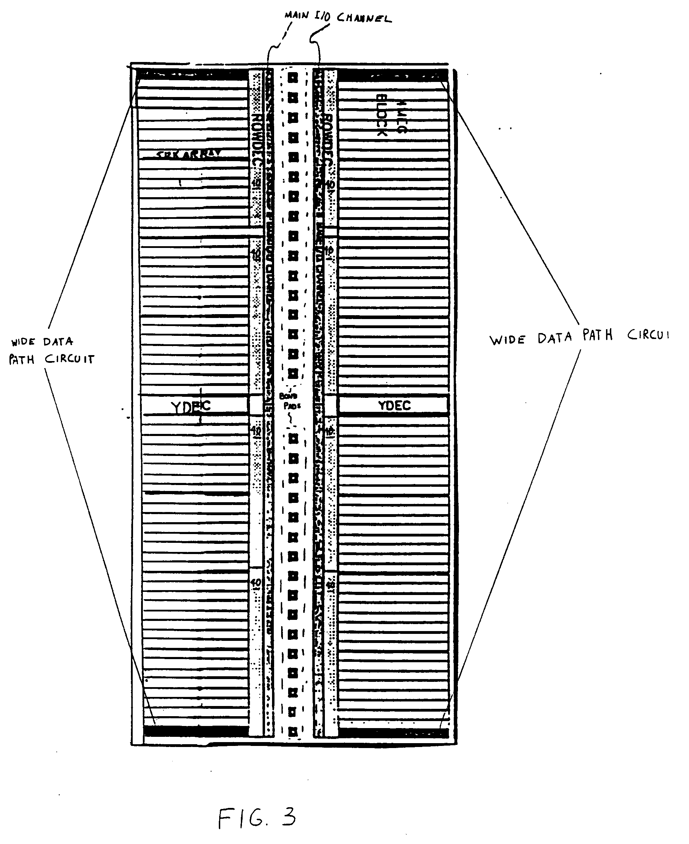

Figure 3 illustrates a plan view of a second preferred embodiment of the invention. this figure is similar to the embodiment shown in Figure 1 except that the wide data path circuits, now shown associated with four 4 megabit memory blocks, are located at each end of the columns of memory. A signal traveling from a Y decoder for sense amp selection allows selection of a sense amp and the import or export of data without back travel across the chip.

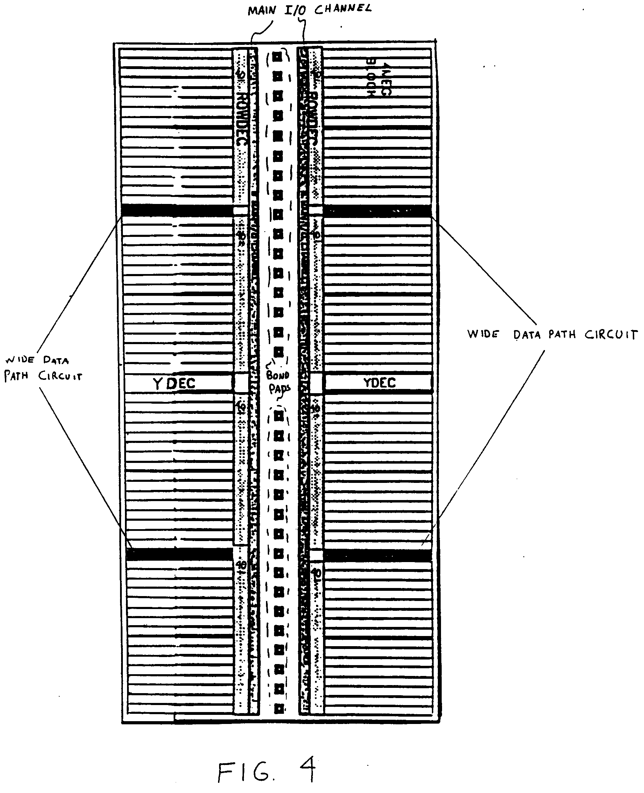

Figure 4 illustrates a plan view of a third preferred embodiment of the invention. this figure is similar to the embodiment shown in figure 3 except that two wide data path circuits centered substantially between a Y decoder and an edge of the chip exist. Signals coming from the Y decoder traveling to the farthest most sense amp only require the sense amp to send or receive a signal half distance as compared with the previous embodiment since the wide data path circuit is at mid point between the Y decoder and the farthest most sense amp. Consequently, signals located between the Y decoder and wide data path circuit provide service faster than the embodiment shown in figure 3.

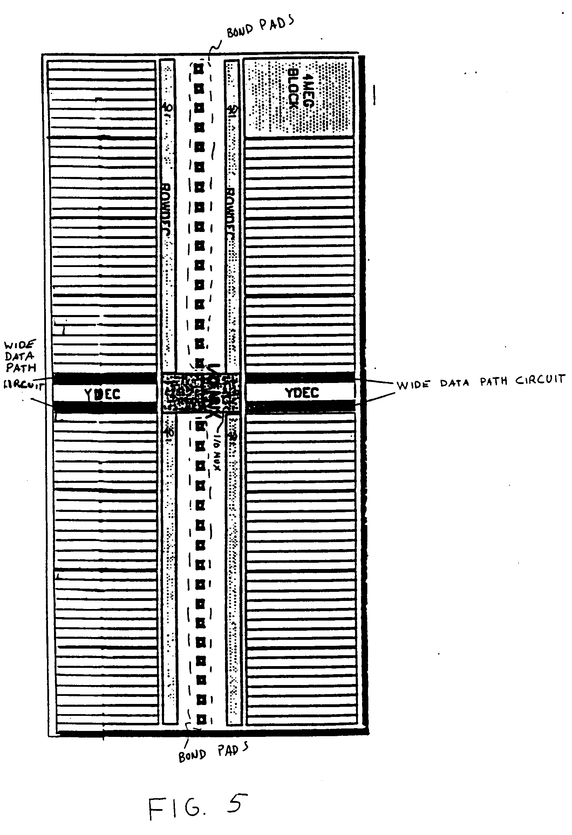

Figure 5 illustrates a fourth preferred embodiment of the invention. This embodiment is similar to the embodiment shown in Figure 4 except that the wide data path circuits abut a Y decoder in each column of the memory cell arrays. Additionally, a row decoder is provided for each column of four 4 megabit blocks of memory as shown. Rather than a columnar channel for input/output flanking the edges of the row decoders, an independent input/output multiplexer I/O MUX is centrally located between the Y decoders and wide data path circuit in the middle of the chip. Although this embodiment provides the longest delay, the time can be minimized by increasing the complexity and thus the power of the centrally located input/output multiplexer.

The foregoing described embodiments of the invention encourage high speed memory operation under constraints of high memory density.

Although the invention has been described in detail herein with reference to its preferred embodiments and certain described alternatives, it is to be understood that this description is by way of example only, and it is not to be construed in a limiting sense. It is further understood that numerous changes in the details of the embodiment of the invention, and additional embodiments of the invention, will be apparent to, and may be made by persons of ordinary skill in the art having reference to this description. It is contemplated that all such changes and additional embodiments are within the spirit and true scope of the invention as claimed below.

## Claims

1. A memory comprising:
a plurality of columns of a plurality of memory arrays of a predetermined size, said arrays being aligned side by side;
a plurality of data path circuits interposed at predetermined intervals between said memory arrays of said predetermined size;
a column decoder located at substantially at the center of each said column of a plurality of memory arrays;
a plurality of row decoders lying alongside each said column of a plurality of memory arrays;
a plurality of bond pads substantially aligned in a column, situated between said column of said plurality of memory arrays.

2. A memory as recited in claim 1 wherein a data path circuit is interspersed in said memory such that a data path circuit is located in each said column of memory arrays after a predetermined number interval of memory arrays of a predetermined number.

3. A memory as recited in claim 1 or claim 2, wherein a data path circuit is located substantially on each edge of each said column of plurality of memory arrays.

4. A memory as recited in any preceding claim, wherein a data path circuit is located in each said column of a plurality of memory arrays substantially between a column decoder and an edge of a column of said plurality of memory arrays.

5. A memory as recited in any preceding claim, wherein said column decoder in each said column of memory arrays is substantially abutted on each of two sides along said column of arrays by two said data path circuits.

6. A memory as recited in claim 5 further comprising an input/output multiplexer substantially centered between said column of bond pads.

7. A memory as recited in any preceding claim, wherein the data path circuits are wide data path circuits.

8. An electronic system including the memory recited in any preceding claim.

9. An electronic system as recited in claim 8 which comprises a television system selected from the group consisting of enhanced definition television and high definition television.

10. An electronic system as recited in claim 8 wherein said system is a telecommunications system.

11. An electronic device including the memory recited in any of claims 1 to 7.
